# NEUE EUROPÄISCHE PATENTSCHRIFT

(11) **EP 0 142 053 B2**
(45) Veröffentlichungstag und Bekanntmachung des Hinweises auf die Entscheidung über den Einspruch: **22.02.1995**
(45) Hinweis auf die Patenterteilung: 29.08.1990
(21) Anmeldenummer: 84112394.6
(22) Anmeldetag: 13.10.1984
(51) Int. Cl.: B60R 16/02, H01C 1/014, H05K 1/18

(54) **Kontrollgerät**
Control device
Dispositif de contrôle

(30) Priorität: 18.10.1983 DE 3337804
(43) Veröffentlichungstag der Anmeldung: 22.05.1985
(73) Patentinhaber: Stribel GmbH, D-72636 Frickenhausen (DE)
(72) Erfinder: Kröner, Otwin, D-7317 Wendlingen (DE); Geber, Michael, D-7436 Römerstein-Böhringen (DE)

(56) Entgegenhaltungen:
- DE-A- 2 537 925
- DE-A- 3 310 756
- US-A- 4 399 819
- Richtungswarnblinkgeber 4DW 004 356-01, Zeichnungs-Nr. A 004 356-01 vom 05.11.81, mit Änderung vom 13.02.84
- System (Gr), Zeichnungsnummer 713 874-01 vom 04.10.82, mit Änderung vom 24.02.83 und dem Hinweis 'Verw. für: 4DW 004 356-01'
- Widerstand-Rohteil, Zeichnungsnummer 713 875-50 vom 22.09.82, mit Änderungen vom 21.08.86 und 07.05.84 und dem Hinweis 'Verw. für 4DM 004 356-00'

## Beschreibung

Die Erfindung betrifft ein Kontrollgerät mit den Merkmalen des Oberbegriffs des Anspruchs 1.

Ein vorbenutzter Richtungswarnblinkgeber 4DW 004 356-01 der Firma Hella KG Hueck & Co., Lippstadt, ist der Zeichnung Nr. A 004 356-01 vom 05.11.81, mit Änderung vom 13.02.84, der Zeichnung Nr. 713 874-01 vom 04.10.82, mit Änderung vom 24.02.83, und der Zeichnung Nr. 713 875-50 vom 22.09.82, mit Änderungen vom 21.08.86 und 07.05.84, zu entnehmen. Dieses Gerät weist eine Blinklichtkontrolle zur Stromkreisüberwachung mit einem Gehäuse, einem Blechstreifenwiderstand, Leiterstegen, Steckkontakten, einer Leiterplatte und einer Auswertelektronik auf. Die Leiterplatte mit der Auswertelektronik und der Blechstreifenwiderstand sind in dem Gehäuse gemeinsam in verschiedenen Ebenen auf Abstand zueinander angeordnet. Die Leiterplatte ist, an einer Grundplatte festgelegt. Außerdem sind die Leiterstege vom Blechstreifenwiderstand quer zu dessen Ebene den Abstand überbrückend zur Leiterplatte umgebogen. Bei diesem Kontrollgerät liegen die Grundplatte des Gehäuses, die Leiterplatte und die Blechstreifenwiderstände in parallelen Ebenen, wobei die den Abstand zur Leiterplatte hin überbrückenden Leiterstege rechtwinklig umgebogen und an der Leiterplatte festgelegt sind. Hierbei ist es nachteilig, daß eine verhältnismäßig große, annähernd quadratische Grundfläche beansprucht wird und eine hohe Temperaturbeanspruchung auftreten kann.

Die Aufgabe der Erfindung besteht darin, ein Kontrollgerät mit den Merkmalen des Oberbegriffs des Anspruchs 1 dahingehend weiterzubilden, daß bei guter Warmeabführung und hoher Widerstandsfähigkeit gegen Kurzschlußbelastung eine platzsparend kompakte Geräteausführung erzielt wird.

Diese Aufgabe wird bei einem Kontrollgerät mit den Merkmalen des Oberbegriffs erfindungsgemäß durch die kennzeichnenden Merkmale des Anspruchs 1 gelöst.

Bevorzugte Ausgestalungen und Weiterbildungen sowie weitere Vorteile und wesentliche Einzelheiten der Erfindung sind den Merkmalen der Unteransprüche, der nachfolgenden Beschreibung und der Zeichnung zu entnehmen, die in schematischer Darstellung bevorzugte Ausführungsformen als Beispiel zeigt. Es stellen dar:
Fig. 1 eine Unteransicht eines erfindungsgemäßen Kontrollgerätes mit an einer Grundplatte angeordneten Kontaktstiften,
Fig. 2 eine Seitenansicht des Kontrollgerätes der Fig. 1 mit erfindungsgemäß mit den Kontaktstiften verbundenen Blechstreifenwiderständen und einer an einer Leiterplatte angeordneten Auswertselektronik innerhalb eines Haubenraumes,
Fig. 3 eine Schnittansicht eines Blechstreifenwiderstandes gemaß der Schnittlinie III der Fig. 2 in einer vergrößerten Darstellung,
Fig. 4 eine linke Stirnseitenansicht des Kontrollgerätes der Fig. 2,
Fig. 5 eine rechte Stirnseitenansicht des Kontrollgerätes der Fig. 2 und
Fig. 6 eine Draufsicht auf das Kontrollgerät der Fig. 2 bei abgenommener Haube in vergrößerter Darstellung.

Das dargestellte Kontrollgerät 1 ist für ein Kraftfahrzeug vorgesehen und kann dazu in eine Stekkeraufnahme eingesteckt werden. Bevorzugt werden jedoch drei Stecker mit entsprechenden Leitungen am Kontrollgerät 1 aufgesteckt. Das Kontrollgerät 1 ist hier insbesondere zur Überwachung von Lichtstromkreisen, wie zum Beispiel Abblendlicht, Fernlicht, Standlicht, Schlußlicht, Bremslicht, Blinklicht, bestimmt. Es liegt jedoch auch im Rahmen der Erfindung, das Kontrollgerät 1 zur Überwachung von anderen Stromkreisen im Kraftfahrzeug einzusetzen, zum Beispiel bei Elektromagnetventilen, Scheiben-, Spiegel- und Sitzheizungen, elektrischen Fensterhebern, Scheibenwischern und dergleichen.

Das Kontrollgerät 1 weist eine Grundplatte 2 auf, die aus einem Isolierstoff besteht und vorzugsweise aus einem entsprechenden Kunststoff hergestellt ist. Die Grundplatte 2 weist eine langgestreckte Rechteckform auf, wobei die Länge der Grundplatte 2 hier etwa vier bis fünf mal größer ist als die Breite. Die Seitenränder 3 der Grundplatte 2 besitzen eine Abstufung 4, in der die Randbereiche 5 einer Haube 6 derart gelagert sind, daß ein formschlüssiger Abschluß ohne störende Vorsprünge gegeben ist. Die Randbereiche 5 der Haube 6 sind dabei zweckmäßig durch eine Klipsbeziehungsweise Schnappbefestigung im Bereich der Abstufung 4 and den Seitenrändern 3 der Grundplatte 2 lösbar befestigt, wobei ein Vorsprung, eine Nase oder dergleichen mittels materialelastischer Federvorspannkraft in eine entsprechende Ausnehmung eingreift.

Die Haube 6 besteht vorteilhaft ebenfalls aus einem isolierenden Kunststoffmaterial und besitzt bei der vorliegenden Ausführung im Bereich des Innenraums 7 eine Trennwand 8, die ebenfalls aus Kunststoff gebildet ist und an der die Seitenwände 9 verbindenden Deckwand 10 materialeinheitlich angeformt ist.

An der nach unten weisenden Außenseite 11 der Grundplatte 2 befinden sich Steckkontakte 12, die hier konkret als Rundsteckerstift ausgeführt sind und in entsprechende Kontaktbuchsen einer Stekkeraufnahme einsetzbar beziehungsweise einsteckbar sind. Dabei kann es auch vorteilhaft sein, die Steckkontakte 12 als Flachstecker auszubilden oder auch als Aufnahmebuchse auszuführen, in die ein Kontaktteil eines Steckers beziehungsweise einer Steckerleiste eingesetzt werden kann.

Die hier als Rundsteckerstift ausgeführten Steckkontakte 12 durchsetzen die Grundplatte 2, an der sie festgelegt sind, und besitzen einen Bund 13, der an der Außenseite 11 der Grundplatte 2 anliegt.

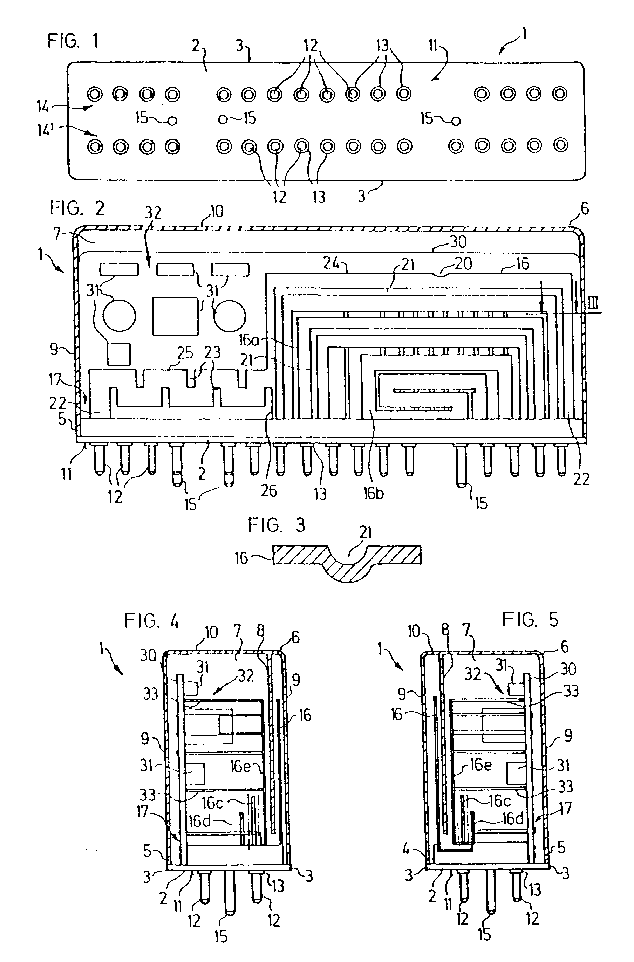

Insbesondere der Fig. 1 ist zu entstehmen, daß die Steckkontakte 12 auf Abstand zueinander in zwei parallelen Reihen 14, 14' angeordnete sind. Es kann jedoch im Rahmen der Erfindung auch vorteilhaft sein, die Steckkontakte 12 zum Beispiel kreisringbildend, zickzackförmig oder anderweitigen Gruppierungen an der Grundplatte 2 anzuordnen. Zwischen den beiden Reihen 14, 14' der Steckkontakte 12 sind Führungszapfen 15 angeordnet, die an der Grundplatte 2 materialeinheitlich angeformt sind und gewährleisten, daß das Kontrollgerät 1 nur in einer ganz bestimmten Position in die zugehörigen Aufnahmesteckerbuchsen am Kraftfahrzeug eingesteckt werden kann, so daß eine Fehlmontage mit Sicherheit verhindert ist.

Im Innenraum 7 der Haube 6 befinden sich verschieden gestaltete Blechstreifenwiderstände 16. Diese Blechstreifenwiderstände 16 bestehen aus einem dünnen Widerstandsblechmaterial, aus dem die Blechstreifenwiderstände 16 herausgestantzt sind. Das Widerstandsblechmaterial kann vorzugsweise Chrom und Nickel enthalten und ist weitgehend beständig gegen Korrosion. Die Blechstreifenwiderstände 16 sind an der Innenseite 17 der Grundplatte 2 festgelegt und besitzen dazu entsprechende Plattenanschlußteile 18, über die die Blechstreifenwiderstände 16 mit den Steckkontakten 12 mittels einer Nietung 19 and der Innenseite 17 fest verbunden sind. Dabei liegt es auch im Rahmen der Erfindung, anstelle einer Nietung die Verbindung der Blechstreifenwiderstände 16 mit den Steckkontakten 12 über eine Verschweißung oder dergleichen herzustellen. Besonders vorteilhaft kann der Blechstreifenwiderstand 16 mit dem Steckkontakt 12 materialeinheitlich einstückig ausgebildet sein, so daß keine besondere Verbindung vorzunehmen ist.

Der Plattenanschlußteil 18 ist zweckmäßig so bemessen, daß seine Breite mindestens der Breite des Blechstreifenwiderstandes 16 entspricht. Vorteilhaft kann die Breite des Plattenanschlußteils 18 größer sein als die Breite des Blechstreifenwiderstandes 16.

Um auch nachträglich einen genauen Abgleich des Blechstreifenwiderstandes 16 erzielen zu können, besteht die Möglichkeit, mit einem entsprechenden Schneid- oder Stanzwerkzeug beziehungsweise einer Schneid- oder Lochzange eine Abgleichausklinkung 20 in den Blechstreifenwiderstand 16 einzubringen, so daß dessen Streifenquerschnitt verjüngt wird, wodurch eine entsprechende Erhöhung des Widerstandswertes erreicht werden kann. Bei einem längeren Blechstreifenwiderstand 16 kann es zur Erhöhrung der Festigkeit und Eigenstabilität günstig sein, eine Versteifungssicke 21 im Blechstreifenwiderstand 16 auszuprägen. Die Versteifungssicke 21 kann sich dabei zweckmäßig in Streifenlängsrichtung erstrecken und muldenbeziehungsweise rillenförmig ausgebildet sein, wie dies insbesondere in der Fig. 3 gezeigt ist. Die verschiedenen Blechstreifenwiderstände 16 des dargestellten Kontrollgerätes 1 besitzen an ihren beiden Endbereichen 22 je einen Steckkontakt 12. Der Verlauf der Blechstreifenwiderstände 16 kann durch entsprechende Freistanzungen 23 mäanderförmig, U-förmig, spiralförmig oder anderweitig verschlungen sein.

Insbesondere der Fig. 2 ist zu entnehmen, daß der Blechstreifenwiderstand 16 in seinem U-förmig ausgebildeten Teil 24 die Versteifungssicke 21 aufweist.

Außerdem besitzt der Blechstreifenwiderstand 16 einen mäanderförmig ausgebildeten Widerstandsteil 25, der entsprechende Freistanzungen 23 besitzt. Zwischen dem Teil 24 und dem Widerstandsteil 25 des Blechstreifenwiderstandes 16 ist ein materialeinheitlicher Abzweig 26 angeordnet. Auch dieser Abzweig 26 ist über einen Plattenanschlußteil 18 mit einem der Steckkontakte 12 verbunden. Der U-förmig ausgebildete Blechstreifenwiderstand 16a, der im U-Bereich des Teils 24 des Blechstreifenwiderstandes 16 sich befindet, weist ebenfalls eine Versteifungssicke 21 auf. Der innerhalb des U-Bereichs des Blechstreifenwiderstandes 16a angeordnete Blechstreifenwiderstand 16b ist durch entsprechende Freistanzungen 23 annähernd spiralförmig verschlungen ausgebildet.

Den Fig. 2 und 4 bis 6 ist zudem zu entnehmen, daß die Blechstreifenwiderstände 16, 16a, 16b, 16c, 16d und 16e senkrecht zur Ebene der Grundplatte 2 an deren Innenseite 17 angeordnet sind, wobei die Anordnung der vorgenannten Blechstreifenwiderstände 16 bis 16e so getroffen worden ist, daß sie parallel zueinander beabstandet sind. Die Plattenanschlulßteile 18 der zur Grundplatte 2 senkrecht stehenden Blechstreifenwiderstände 16 bis 16e sind rechtwinklig zur Ebene der Blechstreifenwiderstände abgebogen und liegen somit in der Ebene der Grundplatte 2. Die Plattenanschlußteile 18 und die Blechstreifenwiderstände 16 bis 16e sind hier zweckmäßig als vorzugsweise in einem Arbeitsgang hergestellte Stanzbiegeteile ausgeführt.

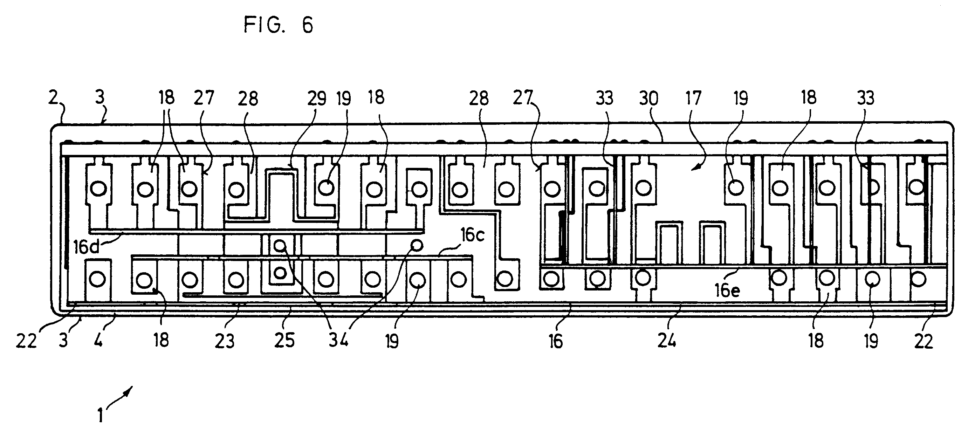

Der Fig. 6 ist zudem zu entnehmen, daß für eine einwandfreie Fixierung und sichere Lagerung der Plattenanschlußteile 18 sich letztere jeweils in einer Ausnehmung 27 befinden. Diese Ausnehmungen 27 sind an der Innenseite 17 der Grundplatte 2 ausgebildet und so bemessen, daß die Plattenanschlußteile 18 weitgehend spielfrei und verdrehungssicher darin gelagert sind, wobei die Ausnehmungen 27 an ihren Seiten von Isolierwänden 28 begrenzt sind, die so ausgebildet sind, daß ihre Höhe mindestens der Blechdicke der Plattenanschlußteile 18 entspricht. Zudem sind Aussparungen 29 an der Innenseite 17 der Grundplatte 2 ausgebildet.

An der Grundplatte 2 des Kontrollgerätes 1 ist eine Leiterplatte 30 angeordnet, die an einem der Seitenränder 3 festgelegt ist und sich über die gesamte Länge der Grundplatte 2 erstreckt. Die Leiterplatte 30 ist so ausgerichtet, daß sie mit ihrer Ebene parallel zu den Blechstreifenwiderständen 16 bis 16e liegt. An der den Blechstreifenwiderständen 16 bis 16e zugewandten Seite der Leiterplatte 30 befinden sich Elektronikbauteile 31, die über Leiterbahnen an der Rückseite der Leiterplatte 30 so zusammengefaßt sind, daß eine Auswertelektronik 32 gebildet ist. Über diese Auswertelektronik 32 werden an den Blechstreifenwiderständen 16 bis 16e eventuell auftretende Spannungsänderungen erfaßt und zur Anzeige gebracht beziehungsweise für eine Signalgabe weitergeleitet.

Die Blechstreifenwiderstände 16 bis 16e weisen dazu mindestens einen Leitersteg 33 auf. Die Enden der Leiterstege 33 durchsetzen die Leiterplatte 30 und sind an den rückseitigen Leiterbahnen durch entsprechend Lötverbindung kontaktiert. Die Leiterstege 33 sind als schmale Streifen ausgeführt, die materialeinheitlich einstückig mit den Blechstreifenwiderständen 16 bis 16e verbunden sind und durch geeignete Schneid- oder Stanzvorgänge von den Blechstreifen freigestanzt und erforderlichenfalls abgebogen sind. Die Leiterstege 33 des Blechstreifenwiderstandes 16e sind von diesem rechtwinklig abgebogen und erstrecken sich quer in Richtung zur Leiterplatte 30, wodurch zusätzlich eine sichere Abstützung gegeben ist. Auch die Plattenanschlußteile 18 können mit Leiterstegen 33 versehen sein die die Leiterplatte 30 durchsetzen und mit deren Leiterbahnen verbunden sind.

Um sicherzustellen, daß auch bei extremen Beanspruchungen keine Beruhrung zwischen den verschiedenen Blechstreifenwiderständen 16 bis 16e erfolgen kann, ist es vorteilhaft, zwischen den Blechstreifenwiderständen mindestens einen Abstandsteil 34 anzuordnen, wie dies insbesondere der Fig. 6 zu entnehmen ist. Hier sind die Blechstreifenwiderstände 16c und 16d mittels als Zapfen ausgebildeten Abstandsteilen 34 distanziert, die aus Kunststoff bestehen und materialeinheitlich and der Grundplatte 2 angeformt sind.

Die die Auswertelektronik 32 bildenden Elektronikbauteile 31, die zum Beispiel integrierte Schaltungen (IC), Transistoren, Dioden, Kondensatoren usw. sein können, sind in der Draufsicht der Fig. 6 nicht dargestellt worden, um die Lage und Anschlüsse der Blechstreifenwiderstände 16 bis 16e besser zu verdeutlichen. Im Falle eines Ausfalls der elektrischen Verbraucher beziehungsweise Verbraucherwiderstände, wie zum Beispiel Glühlampen eines Kraftfahrzeugs, ändert sich die Spannung am jeweils zugehörigen Abfragewiderstand beziehungsweise Blechstreifenwiderstand 16 bis 16e. Diese Spannungsänderung wird von der Auswertelektronik 32 erfaßt und zur Anzeige gebracht. Dies kann zum Beispiel eine optische oder akustische Anzeige sein. Es kann jedoch auch ein elektrisches Signal sein, über das weitere Funktionen, wie zum Beispiel automatische Aus- oder oder Einschaltungen, Verstellungen und dergleichen eingeleitet werden.

Ein wesentlicher Vorteil besteht darin, daß solche als Massenartikel zu bezeichnende Abfragewiderstände beziehungsweise Vorwiderstände einfach und kostengünstig herzustellen sind. In der einfachsten Ausführung kann dabei lediglich ein Blechstreifenwiderstand mit einem Steckkontakt zu einer einsteckbaren Baueinheit ausgebildet sein. Über die Blechstreifenwiderstände 16 erfolgt eine großflächige Wäremeabführung, die auch im Bereich der Anschlüsse gegeben ist, da über die Steckkontakte 12 ebenfalls große Flächen zur Wärmeabführung gegeben sind, so daß kein Wärmestau im Bereich des Widerstandselementes auftreten kann und ein Durchbrennen selbst im Kurzschlußfalle nicht auftritt. Dabei ist aufgrund der erfindungsgemäßen Lösung zudem ein geringes Gewicht gegeben und es besteht die Möglichkeit eines nachträglichen Abgleichs des Widerstandswertes in einfacher Weise, indem an bestimmten Stellen der Blechstreifenwiderstände 16 zum Beispiel mit einer Handzange einfach entsprechende Ausnehmungen beziehungsweise Ausklinkungen in das Streifenmaterial eingebracht werden. Ein weiterer Vorteil besteht darin, daß das erfindungsgemäße Kontrollgerät 1 mit den Blechstreifenwiderständen 16 bis 16e und den Steckkontakten 12 sowie der Auswertelektronik 32 weitgehend erschütterungsunempfindlich ist. Insgesamt ist somit ein insbesondere im Kraftfahrzeugbereich vielfältig anwendbares, ausgesprochen leichtes und zuverlässig funktionierendes Kontrollgerät gegeben, das einen einfachen Aufbau und eine lange Lebensdauer besitzt.

## Patentansprüche

1. Kontrollgerät (1) zur Stromkreisüberwachung mit einem Gehäuse (2, 6), einem Blechstreifenwiderstand (16 bis 16e), Leiterstegen (33), Steckkontakten (12), einer Leiterplatte (30) und einer Auswertelektronik (32), wobei die Leiterplatte (30) mit der Auswertelektronik (32) und der Blechstreifenwiderstand (16 bis 16e) in dem Gehäuse (2, 6) gemeinsam in verschiedenen Ebenen auf Abstand zueinander angeordnet sind und die Leiterplatte (30) an einer Grundplatte (2) festgelegt ist und die Leiterstege (33) vom Blechstreifenwiderstand (16 bis 16e) quer zu dessen Ebene den Abstand überbrückend zur Leiterplatte (30) umgebogen sind, dadurch gekennzeichnet, daß der Blechstreifenwiderstand (16 bis 16e) und die Leiterplatte (30) im wesentlichen rechtwinklig zur Grundplatte (2) angeordnet sind, daß der Blechstreifenwiderstand (16 bis 16e) an der Grundplatte (2) festgelegt ist, daß die Leiterplatte (30) nahe einem Seitenrand (3) der Grundplatte (2) angeordnet ist und daß der Blechstreifenwiderstand (16 bis 16e) einen aus seiner Ebene als Biegeteil etwa rechtwinklig abstrebenden Plattenanschlußteil (18) aufweist, der mit dem Steckkontakt (12) fest verbunden ist.

2. Kontrollgerät nach vorstehendem Anspruch, dadurch gekennzeichnet, daß der Plattenanschlußteil (18) des Blechstreifenwiderstandes (16 bis 16e) mit dem Steckkontakt (12) an der Innenseite (17) der Grundplatte (2) verbunden ist und daß der Steckkontakt die Grundplatte (2) durchsetzt und an deren Außenseite (11) vorsteht.

3. Kontrollgerät nach einem der vorstehenden Ansprüche, dadurch gekennzeichnet, daß der Steckkontakt (12) des Blechstreifenwiderstandes (16 bis 16e) einen an der Außenseite (11) der Grundplatte (2) anliegenden Bund (13) aufweist und daß der mit dem Steckkontakt (12) verbundene Plattenanschlußteil (18) des Blechstreifenwiderstandes (16 bis 16e) in einer von mindestens einer Isolierwand (28) begrenzten Ausnehmung (27) an der Innenseite (17) der Grundplatte (2) angeordnet ist.

4. Kontrollgerät nach einem der vorstehenden Ansprüche, dadurch gekennzeichnet, daß der Steckkontakt (12) des Blechstreifenwiderstandes (16 bis 16e) als Rundsteckerstift ausgebildet ist.

5. Kontrollgerät nach einem der vorstehenden Ansprüche, dadurch gekennzeichnet, daß der Steckkontakt des Blechstreifenwiderstandes (16 bis 16e) als Aufnahmebuchse für einen Kontaktstecker ausgebildet ist.

6. Kontrollgerät nach einem der vorstehenden Ansprüche, dadurch gekennzeichnet, daß mindestens zwei Blechstreifenwiderstände (16 bis 16e) auf Abstand parallel zueinander an der die Steckkontakte (12) aufweisenden Grundplatte (2) angeordnet sind.

7. Kontrollgerät nach einem der vorstehenden Ansprüche, dadurch gekennzeichnet, daß mehrere Steckkontakte (12) eines oder mehrerer Blechstreifenwiderstände (16 bis 16e) auf Abstand zueinander in zwei oder mehr parallelen Reihen (14,14') an der Außenseite (11) der Grundplatte (2) angeordnet sind.

8. Kontrollgerät nach einem der vorstehenden Ansprüche, dadurch gekennzeichnet, daß die Elektronikbauteile (31) der Auswertelektronik (32) an der dem Blechstreifenwiderstand (16 bis 16e) zugewandten Seite angeordnet sind.

9. Kontrollgerät nach einem der vorstehenden Ansprüche, dadurch gekennzeichnet, daß der Blechstreifenwiderstand (16,16a) eine sich vorzugsweise in Streifenlängsrichtung erstreckende einbeziehungsweise ausgeprägte Versteifungssicke (21) aufweist.

10. Kontrollgerät nach einem der vorstehenden Ansprüche, dadurch gekennzeichnet, daß zwischen zwei parallelen Blechstreifenwiderständen (16c bis 16d) mindestens ein Abstandsteil (34) angeordnet ist.

11. Kontrollgerät nach einem der vorstehenden Ansprüche, dadurch gekennzeichnet, daß der Blechstreifenwiderstand (16 bis 16e) und die Leiterplatte (30) mit den Elektronikbauteilen (31) von einer Haube (6) umschlossen sind, die an den Seitenrändern (3) der Grundplatte (2) angeschlossen und vorzugsweise mittels Schnappbefestigung gehalten ist.

12. Kontrollgerät nach einem der vorstehenden Ansprüche, dadurch gekennzeichnet, daß zwischen zwei Blechstreifenwiderständen (16,16e) mindestens eine Trennwand (8) der Haube (6) angeordnet ist.

13. Kontrollgerät nach einem der vorstehenden Ansprüche, gekennzeichnet durch eine Anwendung im Stromkreis von Glühlampen, Magnetventilen, Scheiben-, Spiegel-, Sitzheizungen, Fensterhebern, Scheibenwischern und dergleichen in einem Kraftfahrzeug.

## Claims

1. Monitoring device (1) for monitoring electrical circuits, comprising a casing (2, 6), a strip metal resistor (16 to 16a), conductor webs (13), plug contacts (12), a printed circuit board (30) and an evaluating electronic unit (32), wherein the printed circuit board (30) together with the evaluating electronic unit (32) and the strip metal resistor (16 to 16e) are disposed together in the casing (2, 6) at various levels spaced apart from one another and the printed circuit board (30) is secured to a baseplate (2) and the conductor webs (33) are bent out from the strip metal resistor (16 to 16e) transversely to its plane and bridging across the distance to the printed circuit board (30), characterized in that the strip metal resistor (16 to 16e) and the printed circuit board (30) are disposed substantially perpendicularly to the baseplate (2), that the strip metal resistor (16 to 16e) is secured to the baseplate (2), that the printed circuit board (30) is disposed near one lateral edge (3) of the baseplate (2) and that the strip metal resistor (16 to 16e) comprises a plate connector piece (18) projecting approximately perpendicularly as a bent component out of the plane of the strip metal resistor, which (plate connector piece 18) is firmly connected to the plug contact (12).

2. Monitoring device according to the preceding Claim, characterized in that the plate connector piece (18) of the strip metal resistor (16 to 16e) is connected to the plug contact (12) on the inner face (17) of the baseplate (2) and that the plug contact passes through the baseplate (2) and projects on its outer face (11).

3. Monitoring device according to one of the preceding Claims, characterized in that the plug contact (12) of the strip metal resistor (16 to 16e) comprises a flange (13) bearing against the outer face (11) of the baseplate (2) and that the plate connector piece (18) of the strip metal resistor (16 to 16e) connected with the plug contact (12) is disposed in a recess (27), bounded by at least one insulating wall (28), on the inner face (17) of the baseplate (2).

4. Monitoring device according to one of the preceding Claims, characterized in that the plug contact (12) of the strip metal resistor (16 to 16e) is formed as a round plug pin.

5. Monitoring device according to one of the preceding Claims, characterized in that the plug contact of the strip metal resistor (16 to 16e) is formed as a seating socket for a contact plug.

6. Monitoring device according to one of the preceding Claims, characterized in that at least two strip metal resistors (16 to 16e) are disposed at a distance apart from and parallel to one another on the baseplate (2) possessing the plug contacts (12).

7. Monitoring device according to one of the preceding Claims, characterized in that several plug contacts (12) of one or more strip metal resistors (16 to 16e) are disposed spaced apart from one another in two or more parallel rows ( 14, 14') on the outer face (11) of the baseplate (2).

8. Monitoring device according to one of the preceding Claims, characterized in that the electronic components (31) of the evaluating electronic unit (32) ale disposed on the side facing towards the strip metal resistor (16 to 16e).

9. Monitoring device according to one of the preceding Claims, characterized in that the strip metal resistor (16, 16a) possesses an inwardly or outwardly embossed stiffening beading (21) extending preferably longitudinally of the strip.

10. Monitoring device according to one of the preceding Claims, characterized in that at least one spacer piece (34) is disposed between two parallel strip metal resistors (16c to 16d).

11. Monitoring device according to one of the preceding Claims, characterized in that the strip metal resistor (16 to 16e) and the printed circuit board (30) together with the electronic components (31) are surrounded by a hood (6), which is connected to the lateral edges (3) of the baseplate (2) and is secured preferably by snap fixing.

12. Monitoring device according to one of the preceding Claims, characterized in that at least one partition wall (8) of the hood (6) is disposed between two strip metal resistors (16, 16e).

13. Monitoring device according to one of the preceding Claims, characterized by a use in the electrical circuit of incandescent lamps, solenoid valves, window pane heaters, mirror heaters, seat heaters, window winders, window pane wipers and the like in an automobile.

## Revendications

1. Dispositif de contrôle (1) pour la surveillance du circuit électrique, comprenant un boîtier (2, 6), une résistance à bande de tôle (16 à 16e), des barres conductrices (33), des contacts à fiche (12), une plaquette de circuit imprimé (30) et une électronique d'exploitation (32), la plaquette à circuit imprimé (30) avec l'électronique d'exploitation (32) et la résistance à bande de tôle (16 à 16e) étant disposées en commun dans le boîtier et fixées à distance les unes des autres sur la plaque de base (2) dans des plans différents, les barres conductrices (33) étant repliées par rapport à la plaquette à circuit imprimé (30), en partant de la résistance à bande de tôle (16 à 16e), perpendiculairement à son plan et en pontant l'espacement, caractérisé en ce que :
- la résistance à bande de tôle (16 à 16e) et la plaquette à circuit imprimé (30) sont disposées sensiblement perpendiculairement à la plaque de base (2),
- la résistance à bande de tôle (16 à 16e) est fixée à la plaque de base (2),
- la plaquette à circuit imprimé (30) est disposée à proximité d'un bord latéral (3) de la plaque de base (2),
- la résistance à bande de tôle (16 à 16e) présente une partie de raccordement plate (18) rigidement reliée au contact à fiche (12) réalisé sous la forme d'une partie flexible perpendiculaire au plan de la résistance (16 à 16e).

2. Dispositif de contrôle selon la revendication précédente, caractérisé en ce que la partie de raccordement plate (18) de la résistance à bande de tôle (16 à 16e) est reliée au contact à fiche (12) sur la face intérieure (17) de la plaque de base (2) et le contact à fiche (12) traverse la plaque de base (2) et dépasse sur sa face extérieure (11).

3. Dispositif de contrôle selon l'une des revendications précédentes, caractérisé en ce que le contact à prise (12) de la résistance à bande de tôle (16 à 16e) présente une collerette (13) accolée sur la face extérieure (11) de la plaque de base (2) et la partie de raccordement plat (18) de la résistance à bande de tôle (16 à 16e) reliée au contact à prise (12) est disposée dans un évidement (27) délimité par au moins une paroi isolante (28), sur la face intérieure (17) de la plaque de base (2).

4. Dispositif de contrôle selon l'une des revendications précédentes, caractérisé en ce que le contact à prise (12) de la résistance à bande de tôle (16 à 16e) est réalisé sous la forme d'une broche de prise mâle ronde.

5. Dispositif de contrôle selon l'une des revendications précédentes, caractérisé en ce que le contact à prise (12) de la résistance à bande de tôle (16 à 16e) est réalisé sous la forme d'une prise femelle pour une prise de contact.

6. Dispositif de contrôle selon l'une des revendications précédentes, caractérisé en ce qu'au moins deux résistances à bande de tôle (16 à 16e) sont disposées à distance, parallèlement, sur la plaque de base (2) présentant les contacts à prise (12).

7. Dispositif de contrôle selon l'une des revendications précédentes, caractérisé en ce que plusieurs contacts à prise (12) d'une ou de plusieurs résistances à bande de tôle (16 à 16e) sont disposés à distance l'un de l'autre, en deux rangées parallèles (14, 14') ou plus, sur la face extérieure (11) de la plaque de base (2).

8. Dispositif de contrôle selon l'une des revendications précédentes, caractérisé en ce que les constituants électroniques (31) de l'électronique d'exploitation (32) sont disposés sur la face qui est tournée vers la résistance à bande de tôle (16 à 16e).

9. Dispositif de contrôle selon l'une des revendications précédentes, caractérisé en ce que la résistance à bande de tôle (16, 16a) présente une moulure de renforcement (21) s'étendant avantageusement dans le sens longitudinal des bandes formée en constituant une partie en retrait ou un relief.

10. Dispositif de contrôle selon l'une des revendications précédentes, caractérisé en ce qu'au moins une partie d'écartement (34) est disposée entre deux résistances à bande de tôle parallèles (16c, 16d).

11. Dispositif de contrôle selon l'une des revendications précédentes, caractérisé en ce que la résistance à bande de tôle (16 à 16e) et la plaquette à circuit imprimé (30) comportant les composants électroniques (31) sont entourées d'un capot (6) délimité aux bords latéraux (3) de la plaque de base (2) et maintenu de préférence au moyen d'une fixation à cliquet.

12. Dispositif de contrôle selon l'une des revendications précédentes, caractérisé en ce qu'au moins une paroi de séparation (8) du capot (6) est disposée entre deux résistances à bande de tôle (16 à 16e).

13. Dispositif de contrôle selon l'une des revendications précédentes, caractérisé par une utilisation dans le circuit électrique de lampes à incandescence, d'électrovannes, de chauffage de vitres, de miroirs ou rétroviseurs, de sièges, de lève-vitres, d'essuie-glace et analogues dans un véhicule.
